# EUROPEAN PATENT APPLICATION

(11) **EP 4 422 362 A2**
(43) Date of publication of application: **28.08.2024**
(21) Application number: 24157949.9
(22) Date of filing: 15.02.2024
(51) Int. Cl.: H05K 1/11, H05K 3/32

(54) **SACRIFICIAL SOLDER LAYER FOR BROACHING CLINCH NUT ASSEMBLY**

(30) Priority: 24.02.2023 US 202318174031
(71) Applicant: Nokia Solutions and Networks Oy, 02610 Espoo (FI)
(72) Inventor: FAZARI, Daniel, Carleton Place, K7C3W7 (CA); CHAN, Alex, Ottawa, K2J5X9 (CA)
(74) Representative: Swindell & Pearson Limited

(57) **Abstract**

A printed circuit board (PCB) 202 including: a first through hole 206; a first conductive pad 204 on a surface of the PCB, wherein the first conductive pad has a first surface treatment; a reflowed solder layer on the first surface treatment; and a first clinch nut 100 pressed into the first through hole 206, wherein the first clinch nut is pressed into contact with the solder layer to create electrical connectivity between the first clinch nut 100 and the first conductive pad 204.

## Description

### FIELD OF THE DISCLOSURE

Various exemplary embodiments disclosed herein relate to a sacrificial solder layer for broaching clinch nut assembly.

### BACKGROUND

Printed circuit boards (PCBs) utilize broaching clinch nuts to produce threaded holes for mechanical fasteners. The broaching clinch nuts are installed by pressing the nut into the board. The pressing process may be destructive to the PCB inner layers and if done improperly may induce shorts. Volume manufacturers may prefer to press multiple clinch nuts at a time - which means that a certain portion of the clinch nuts are over-seated and a certain portion are under-seated due to the clinch nut head dimension having a manufacturing tolerance. The installation of clinch nuts is typically a force driven process, meaning that the clinch nut has to make contact with a surface to know when it is seated. If an operator or engineer does not properly control the process, the board may be damaged irreparably. This installation is completed after all soldered components are assembled which creates a very expensive defect if the clinch nut were to irreparably damage the PCB.

### SUMMARY

A summary of various exemplary embodiments is presented below. Some simplifications and omissions may be made in the following summary, which is intended to highlight and introduce some aspects of the various exemplary embodiments, but not to limit the scope of the invention. Detailed descriptions of an exemplary embodiment adequate to allow those of ordinary skill in the art to make and use the inventive concepts will follow in later sections.

Various embodiments relate to a printed circuit board (PCB) including: a first through hole; a first conductive pad on a surface of the PCB, wherein the first conductive pad has a first surface treatment; a reflowed solder layer on the first surface treatment; and a first clinch nut pressed into the first through hole, wherein the first clinch nut is pressed into contact with the solder layer to create electrical connectivity between the first clinch nut and the first conductive pad.

Various embodiments are described, wherein the first clinch nut includes ridges that contact an inner surface of the first through hole.

Various embodiments are described, wherein the solder layer extends continuously around the first through hole.

Various embodiments are described, wherein the first conductive pad has a surface treatment; and the solder layer is an additional layer to the surface treatment.

Various embodiments are described, wherein the solder layer includes separate solder portions placed at separate locations around the first through hole.

Various embodiments are described, further including: a second through hole; a second conductive pad on a surface of the PCB, wherein the second conductive pad has a second surface treatment; a reflowed solder layer on the second surface treatment; and a second clinch nut pressed into the second through hole, wherein the second clinch nut is pressed into contact with the solder layer to create electrical connectivity between the second clinch nut and the second conductive pad.

Further various embodiments relate to a method of manufacturing a printed circuit board (PCB) including: placing solder on a surface treatment of a first conductive pad on a surface of the PCB, wherein the first conductive pad is around a first through hole; reflowing said solder; and pressing a first clinch nut into the solder to create electrical connectivity between the first clinch nut and the first conductive pad.

Various embodiments are described, wherein the first clinch nut includes ridges that contact an inner surface of the first through hole.

Various embodiments are described, wherein the solder extends continuously around the first through hole.

Various embodiments are described, wherein the solder includes separate solder portions placed at separate locations around the first through hole.

Various embodiments are described, further including: placing solder on a surface treatment of a second conductive pad on the surface of the PCB, wherein the second conductive pad is around a second through hole; and pressing a second clinch nut into the solder to create electrical connectivity between the second clinch nut and the second conductive pad.

Further various embodiments relate to a printed circuit board (PCB) including: a first through hole; a first conductive pad on a surface of the PCB; a first clinch nut pressed into the first through hole; and a first washer around an insert portion of the first clinch nut, wherein the first washer is in contact with and between the first clinch nut and the first conductive pad and the first washer creates electrical connectivity between the first clinch nut and the first conductive pad.

Various embodiments are described, wherein the first clinch nut includes ridges that contact an inner surface of the first through hole.

Various embodiments are described, wherein the first washer is a conical washer.

Various embodiments are described, wherein the first washer is made of a soft malleable and compressible conductive material.

Various embodiments are described, wherein the first washer is a split washer.

Various embodiments are described, further including: a second through hole; a second conductive pad on a surface of the PCB; a second clinch nut pressed into the second through hole; and a second washer around an insert portion of the second clinch nut, wherein the second washer is in contact with and between the second clinch nut and the second conductive pad and the second washer creates electrical connectivity between the second clinch nut and the second conductive pad.

### BRIEF DESCRIPTION OF DRAWINGS

In order to better understand various exemplary embodiments, reference is made to the accompanying drawings in the following listing.
FIGs. 1A-1D illustrate top perspective, bottom perspective, side, and cross-sectional views of a clinch nut.
FIGs. 2A and 2B illustrate a side and cross-sectional view of the clinch nut inserted into a through hole of the PCB .
FIG. 2C illustrates a cross-sectional view of the clinch nut inserted into the through hole, but with a gap between the head bottom surface and the conductive pad .
FIG. 3 illustrates a press pressing in multiple clinch nuts into the PCB at the same time.
FIG. 4A illustrates a top view of the conductive pad and through hole on the PCB .
FIG. 4B illustrates the use of a solder mask to facilitate the placement of solder on the conductive pad.
FIGs. 4C and 4D illustrate solder being placed in four and two separate locations around the conductive pad, respectively.
FIG. 5 illustrates a cross-sectional view of the clinch nut inserted in the through hole of the PCB with the solder between the head bottom surface and the conductive pad .
FIGs. 6A-6C illustrate the use of a washer with the clinch nut.
FIGs. 7A and 7B illustrate a top perspective and cross-sectional view of the washer .

To facilitate understanding, identical reference numerals have been used to designate elements having substantially the same or similar structure and/or substantially the same or similar function.

### DETAILED DESCRIPTION

The description and drawings illustrate the principles of the invention. It will thus be appreciated that those skilled in the art will be able to devise various arrangements that, although not explicitly described or shown herein, embody the principles of the invention and are included within its scope. Furthermore, all examples recited herein are principally intended expressly to be for pedagogical purposes to aid the reader in understanding the principles of the invention and the concepts contributed by the inventor(s) to furthering the art and are to be construed as being without limitation to such specifically recited examples and conditions. Additionally, the term, "or," as used herein, refers to a non-exclusive or (i.e., and/or), unless otherwise indicated (e.g., "or else" or "or in the alternative"). Also, the various embodiments described herein are not necessarily mutually exclusive, as some embodiments can be combined with one or more other embodiments to form new embodiments.

Printed circuit boards (PCBs) utilize clinch nuts to produce threaded holes for mechanical fasteners. Clinch nuts are installed by pressing the clinch nut into the PCB. The pressing process may be destructive to the PCB inner layers and if done improperly may induce shorts. Volume manufacturers will press multiple at a time - which means that a certain portion of the PEM nuts may be over-seated and a certain portion may be under-seated due to the clinch nut head dimension having a manufacturing tolerance. The installation of broaching clinch nuts is typically a force driven process, meaning that the nut has to make contact with a surface to know when it is seated. If an operator or engineer does not properly control the process, the board may be damaged irreparably. The challenge with the press-fit process is, even with extensive validation, the tolerances of the clinch nut and PCB will vary the force required to seat the clinch nut ideally. This installation is completed after all soldered components are assembled which creates a very expensive defect if the nut were to irreparably damage the PCB. There is presently no way to guarantee a broaching clinch nut is electrically grounded without the use of a plated through hole, through the press fit process, without risking damage to the printed circuit board. Certain PCB design implications do not allow for broaching clinch nut through holes to be plated.

As described above, the main issue is that there is no way to guarantee a broaching clinch nut will be electrically grounded without the risk of significant damage to the PCB. This problem is amplified when volume manufacturing facilities elect to press multiple clinch nuts at once for time and/or cost savings. Due to the tolerance on the clinch nut head, the manufacturers either need to excessively press the nuts to get them all grounded or press until one nut is touching the PCB surface and leave the rest not fully installed because of these tolerances.

The embodiments described herein address the problems in three stages. First, a solder layer is added that acts as a sacrificial layer to press the clinch nut into while minimizing deflection on inner PCB layers. Second, by giving the clinch nut a solder layer to deflect, the clinch nut can act as a solid electrical grounding point because of contact with the solder layer and hence the conductive pad. Secondly, a volume manufacturing facility will press multiple broaching clinch nuts at a time to minimize processing time. The clinch nut heads are all made to tolerance of, for example, +/- 5 mils. As a result only one clinch nut out of the batch will be seated if the nuts are pressed perfectly, i.e., the pressing operation stops as the force required to produce a small movement increases suddenly indicating that the clinch nut has contacted the PCB. More nuts will be properly seated if the volume manufacturer decides to over-press the lot, but the integrity of the PCB will be compromised to an extent.

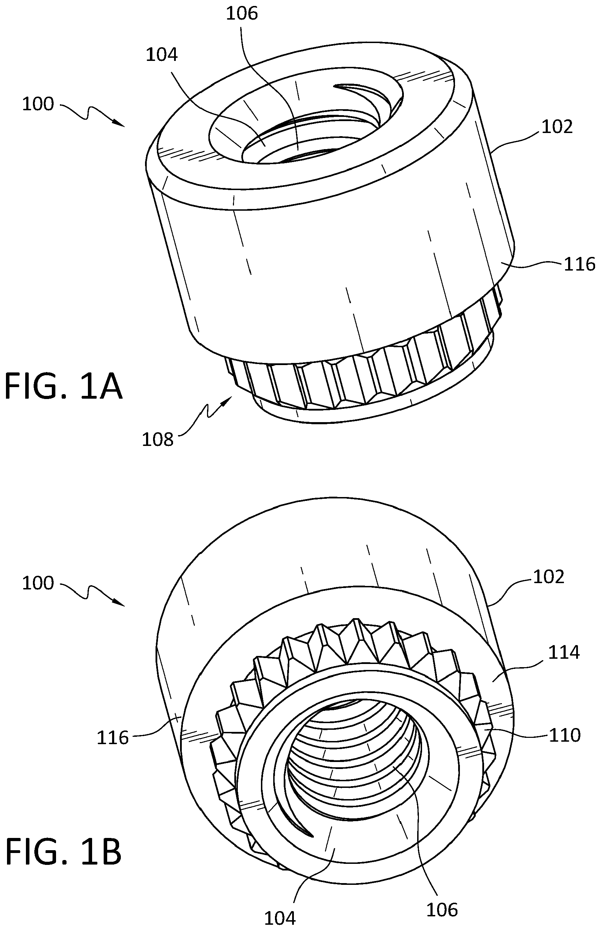

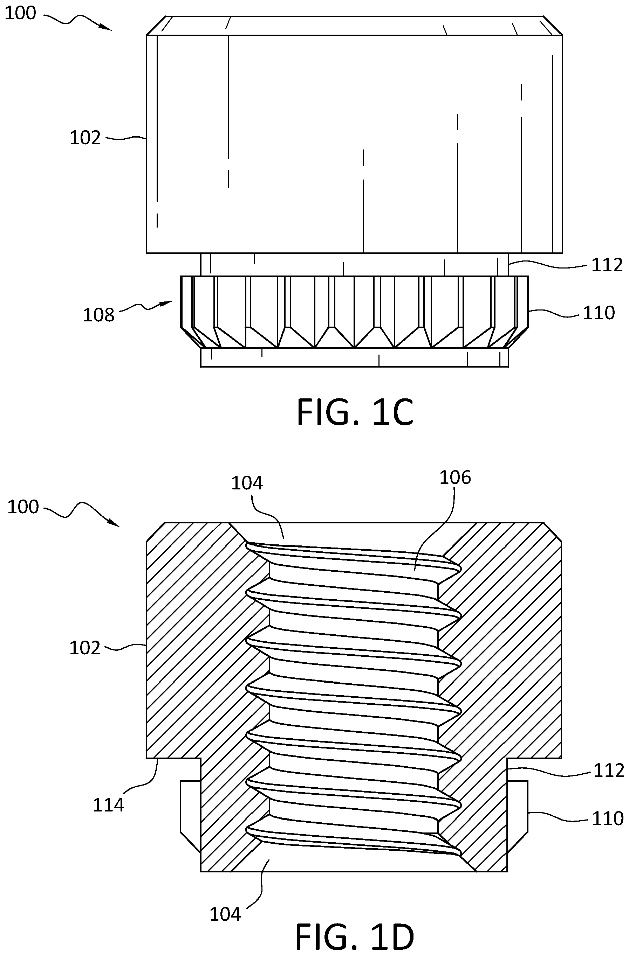

FIGs. 1A-1D illustrate top perspective, bottom perspective, side, and cross-sectional views of a clinch nut 100. The clinch nut 100 includes a head 102 and insert 108. The head 102 has an opening 104 with threads 106. The opening 104 is intended to receive a screw so that various components may be connected to the clinch nut 100 and hence the PCB. Further, as the clinch nut 100 is conductive, this proves an electrical connection between the component and the PCB. This may be used for grounding a component such as, for example, a heat sink. The head 102 has a head outer surface 116. The head 102 has a head bottom surface 114 that may come into contact with a conductive layer or pad on the PCB to provide the electrical connectivity. The head 102 is illustrated as being cylindrical, but other shapes may be used as well.

The insert 108 extends from the head 102 and is intended to enter a through hole on the PCB and to engage the through hole to secure the clinch nut 100 to the PCB. The insert 108 may include ridges 110 that grip the through hole in order to facilitate a secure connection between the clinch nut 100 and the PCB. The ridges 110 may take any shape that facilitates a secure engagement of the insert 108 with the through hole of the PCB. In some situations the insert 108 may not have the ridges 110, but instead will be sized and shaped to securely engage the through hole. The insert 108 is illustrated as being generally cylindrical, but other shapes may be used as long as they conform with and are complementary to the shape of the through hole in the PCB. Further, the ridges 110 may not extend along the length of the insert 108 as illustrated so that there is a gap 112 between the ridges 110 and the head bottom surface 114.

The clinch nut 100 may come in various lengths and diameters depending on the specific application. The length of the head 102 will be sized to provide distance between the component attached to the clinch nut 100 and the PCB. Further, the length of the insert 108 will be based upon the thickness of the PCB. In some situations the clinch nut 100 may be double sided so that the insert 108 may extend through the through hole in the PCB and provide a connection point on the other side of the PCB.

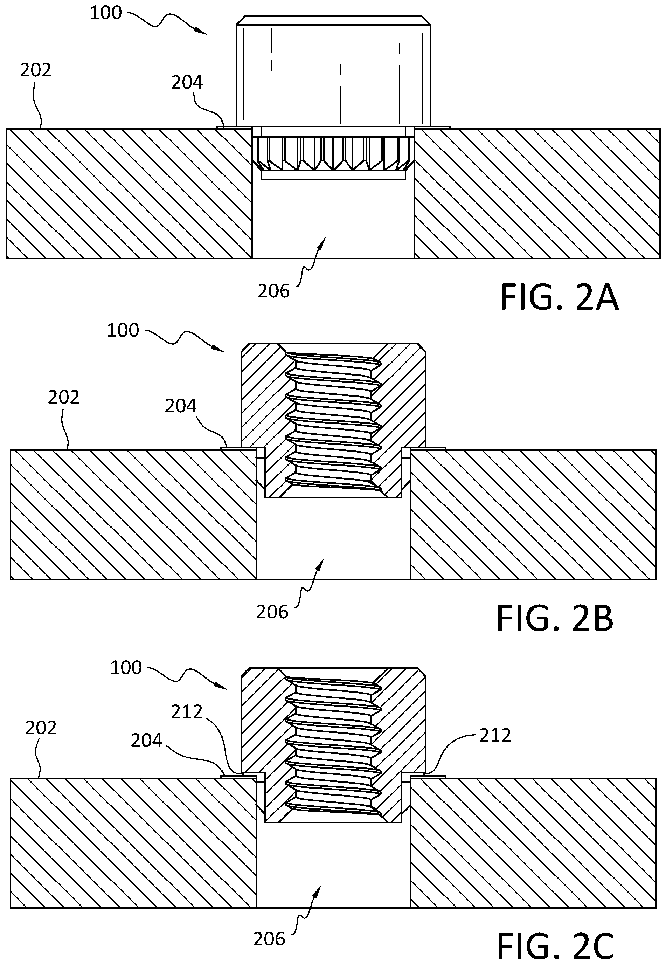

FIGs. 2A and 2B illustrate a side and cross-sectional view of the clinch nut 100 inserted into a through hole 206 of the PCB 202. The PCB 202 includes a conductive pad 204 that surrounds the through hole 206 at the surface of the PCB 202. When the clinch nut 100 is correctly pressed into the through hole 206, the head bottom surface 114 comes into contact with the conductive pad 204. Further, the ridges 110 of the insert 108 engage an inner surface of the through hole 206 so that the clinch nut 100 is securely attached to the PCB 202.

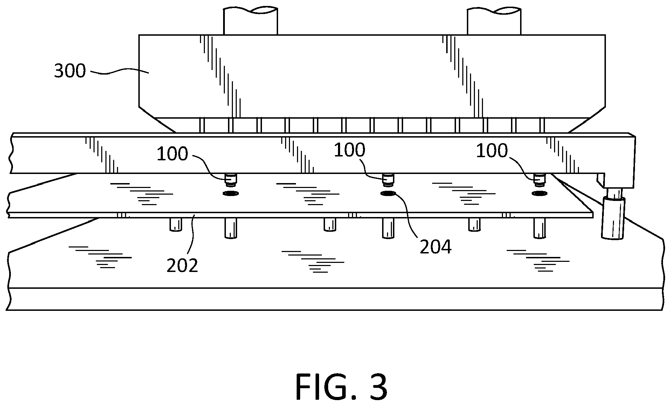

FIG. 2C illustrates a cross-sectional view of the clinch nut 100 inserted into the through hole 206, but with a gap 212 between the head bottom surface 114 and the conductive pad 204. There are a few different ways as mentioned above where the gap 212 between the head bottom surface 114 and the conductive pad 204 may occur. One way, is when the clinch nut 100 is pressed into the PCB 202 and the layers of the PCB 202 are compressed, and then when the die used by the press is removed from the clinch nut 100, the compressed layers of the PCB 202 relax causing the clinch nut 100 to move slightly out of the through hole 206. This can cause the gap 212 to occur. Another way is when multiple clinch nuts 100 are pressed into the PCB 202 at the same time. This practice is common in order to save processing time and cost. As discussed above, because of different manufacturing tolerances in the clinch nuts 100 and the dies used to engage the clinch nuts 100, one of the clinch nuts 100 will engage the PCB 202 before the others, and the press will detect the contact and stop pressing the clinch nuts 100 into the PCB 202. As a result, the shorter clinch nuts 100 may not contact the conductive pad 204 resulting in the gap 212. FIG. 3 illustrates a press 300 pressing in multiple clinch nuts 100 into the PCB 202 at the same time.

Embodiments using a solder layer will now be described that overcome these problems. The embodiment using solder is relatively simple to implement, and the benefits are numerous. This embodiment includes a reflowed solder layer, either over the full clinch nut footprint or in selected regions. The solder layer may be added at the reflow or wave stage during PCB processing. At the reflow stage, the standard solder paste stencil may be modified to accommodate an aperture for the clinch nut head footprint. At the wave solder stage, the wave solder fixture may have an opening to allow solder to wet the conductive pad 204. After the soldering of components to the PCB is complete including the reflow of the solder, the clinch nuts 100 are pressed into the designated through holes 206 on the PCB 202. The solder is meant to make contact with the head 102. This solder acts as a contact point for the clinch nut 100 and is not soldered to the clinch nut 100 itself.

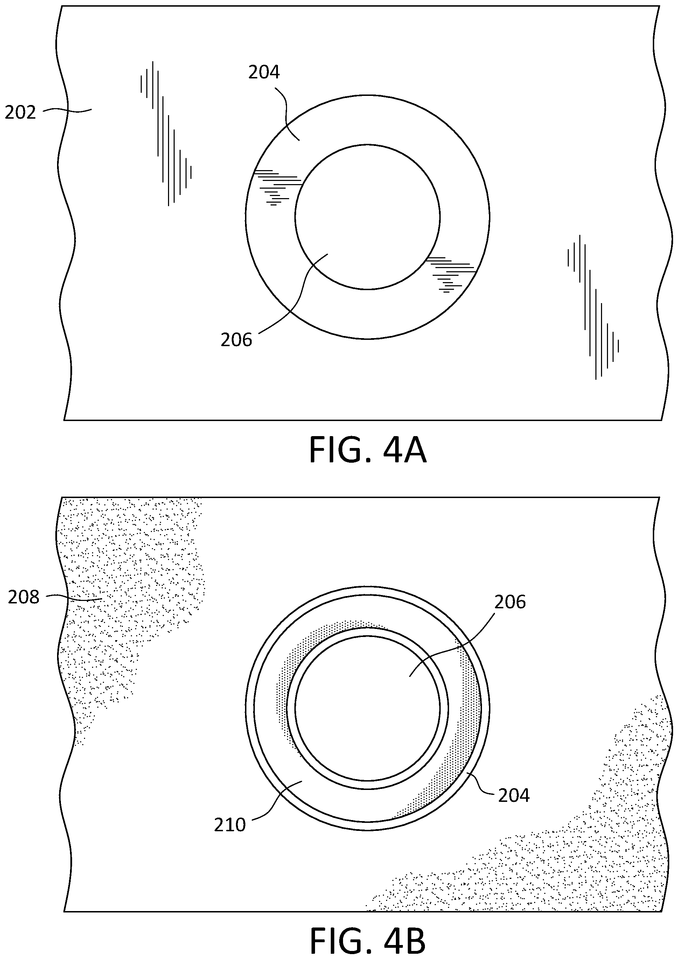

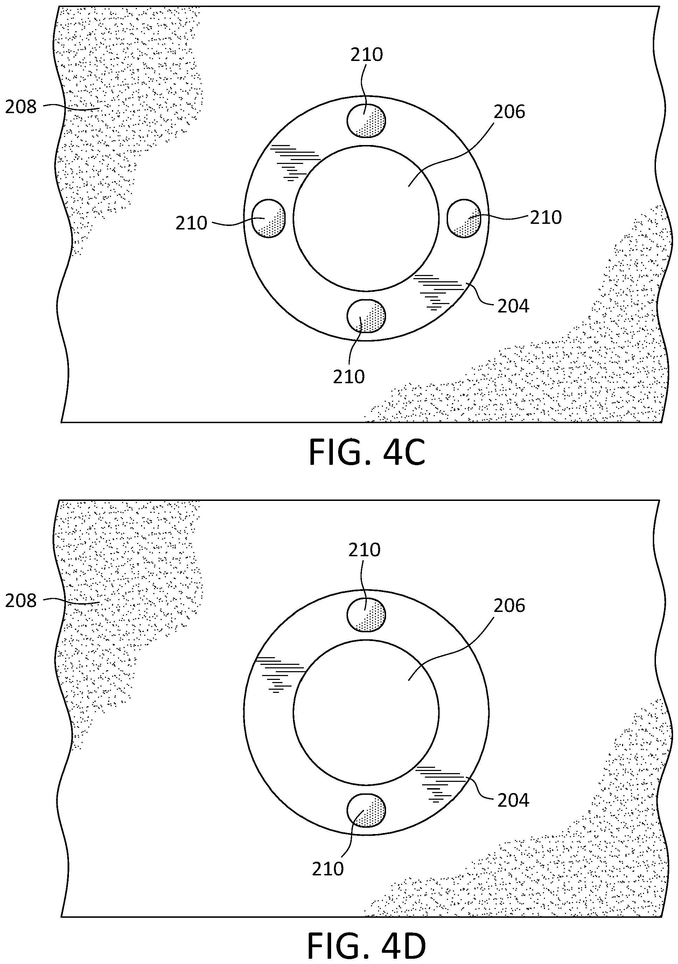

FIG. 4A illustrates a top view of the conductive pad 204 and through hole 206 on the PCB 202. FIG. 4B illustrates the use of a solder mask 208 to facilitate the placement of solder 210 on the conductive pad 204. In FIG. 4B, the solder 210 is placed all around the conductive pad 204. FIGs. 4C and 4D illustrate solder 210 being placed in four and two separate locations around the conductive pad 204, respectively. The embodiments of FIGs. 4C and 4D mean less solder is used and may result in faster processing. Solder may be placed in one or more locations on the conductive pad 204 and the amount of solder placed is chosen to ensure that the clinch nut 100 will be reliably electrically connected to the conductive pad 204. Further, the thickness of the solder 210 is selected to ensure that the solder 210 connects the clinch nut 100 to the conductive pad 204 in light of the tolerances of the clinch nut 100.

Most PCBs require a layer less reactive to environmental contaminants coating exposed copper surfaces. This delays the effects of airborne atoms and compounds from tarnishing the copper surface, thus preserving the copper's solderability for greater lengths of time than without any additional coating or treatment. Common surface treatments or finishes include electroless nickel immersion gold (ENIG), immersion silver, immersion tin, organic solderability preserve and hot air solder levelling (HASL), but many other finishes exist. Soldering processes are typically completed on finished copper surfaces, and may evaporate, dissolve, or plate over the finished materials.

Most surface finishes are thinner and of different material composition than a solder layer. One notable exception is the HASL finish - which is preemptively soldering un-tarnished bare copper to prevent tarnishing rather than finishing it with an alternate barrier layer. HASL will typically be thinner than an additional solder layer, and less precisely controlled. HASL is uncommon to use on products within the telecommunications industry, and poorly suited to most fine pitch interconnect applications. A lab can distinguish between HASL and the embodiments described herein on a customer product by the height of the additional solder layer, whether all outer layer copper on the PCB has a somewhat uniformly thick coating of solder, and/or whether there are additional metals in the solder joint representative of the surface finish used.

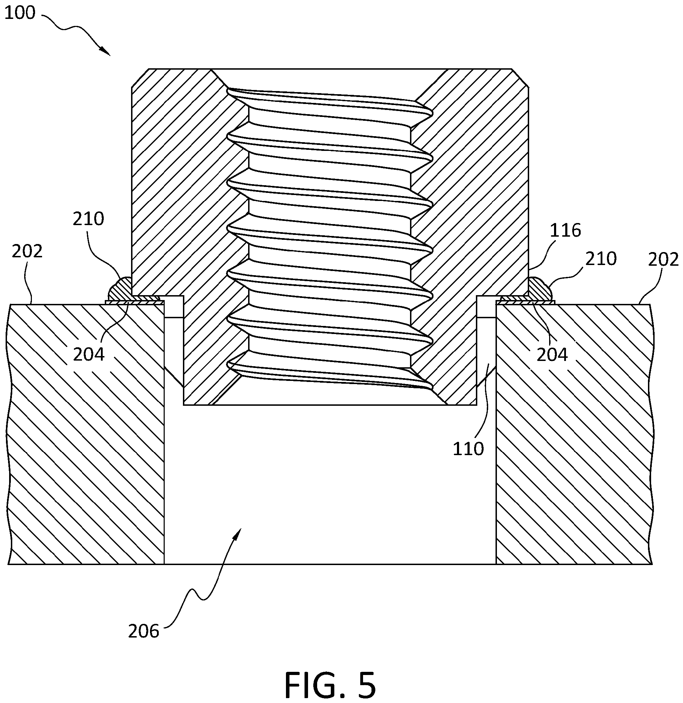

FIG. 5 illustrates a cross-sectional view of the clinch nut 100 inserted in the through hole 206 of the PCB 202 with the solder 210 between the head bottom surface 114 and the conductive pad 204. Once, the solder 210 has been placed on the conductive pad 204 and the PCB 202 is ready to have the clinch nuts 100 inserted, the clinch nuts 100 are placed on the PCB 202 and pressed into the through hole 206 and the solder 210. As the clinch nut 100 is pressed into the solder 210, the solder 210 is deformed an pressed out from between the head bottom surface 114 and the conductive pad 204. The press operates by monitoring the distance pressed verses the force applied. A plot of this relationship shows a fairly linear slope to a plot of distance verses the force applied, until the clinch nut 100 comes into contact with the PCB 202, at which point the slope of this plot becomes almost vertical. This change in the slope may be monitored and indicate to the press that the clinch nut 100 is seated.

As a result, when multiple clinch nuts 100 are pressed into the PCB 202 with different tolerances, when the longest clinch nut 100 contacts the PCB 202 and causes the press to stop, the solder 210 will fill any remaining gaps between the head bottom surface 114 and the conductive pad 204. This will result in electrical connectivity between the clinch nut 100 and the conductive pad 204 and hence between the component attached to the clinch nut 100 and the PCB 202. The solder 210 further helps when there is slight relaxation of the PCB 202 that causes the clinch nut 100 to move out of the through hole 206, because parts of the 210 will still maintain contact with the head 102 of the clinch nut 100 to preserve electrical connectivity.

One use case of this technology is to electrically ground mechanical members such as heat sinks. Referring back to the three main issues detailed above, the use of solder aims to: act as a sacrificial layer to minimize the damage on the PCB 202 inner layers inherent to the clinch nut process; act as a point to electrically connect the clinch nut 100 to the PCB 202; and accommodate for the pressing of multiple clinch nuts 100 at once by planning for the solder 210 to be compressed completely out from between the clinch nut 100 and the conductive pad 204, and accounting for the other clinch nuts 100 to still make physical contact with the partially compressed solder 210 to preserve electrical connectivity.

Installing the clinch nut 100 using the solder 210 may be carried out with the following steps. First, solder 210 may be placed on the conductive pads 204 around through holes 206 that will receive clinch nuts 100. This may be done by placing a solder mask over the PCB 202 and placing solder where it is needed. This may be done during the reflow state of manufacturing the PCB 202. If wave soldering is being used, then this may be done during the wave solder stage. Next, one or more clinch nuts 100 are loaded onto a die and then pressed into the PCB using a press.

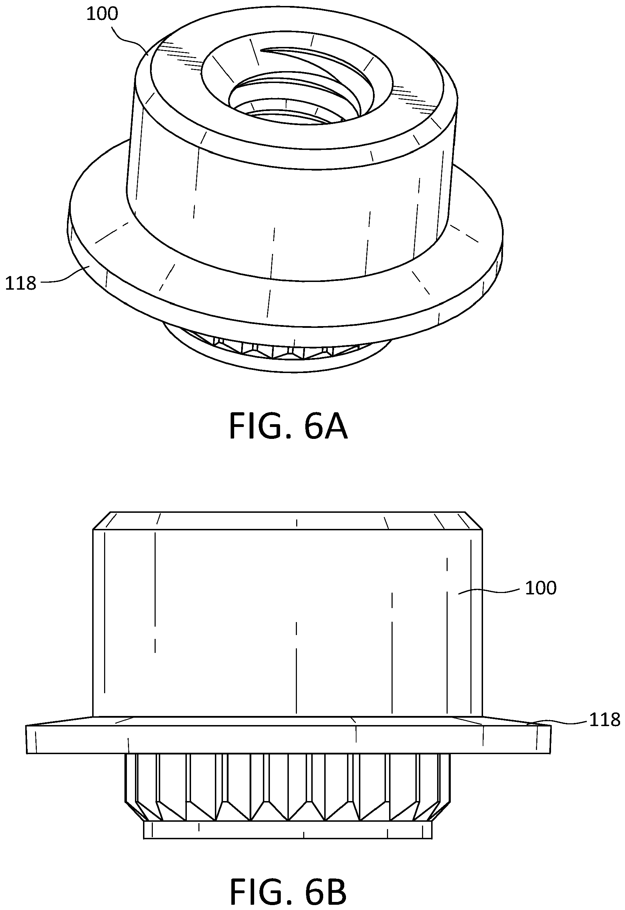

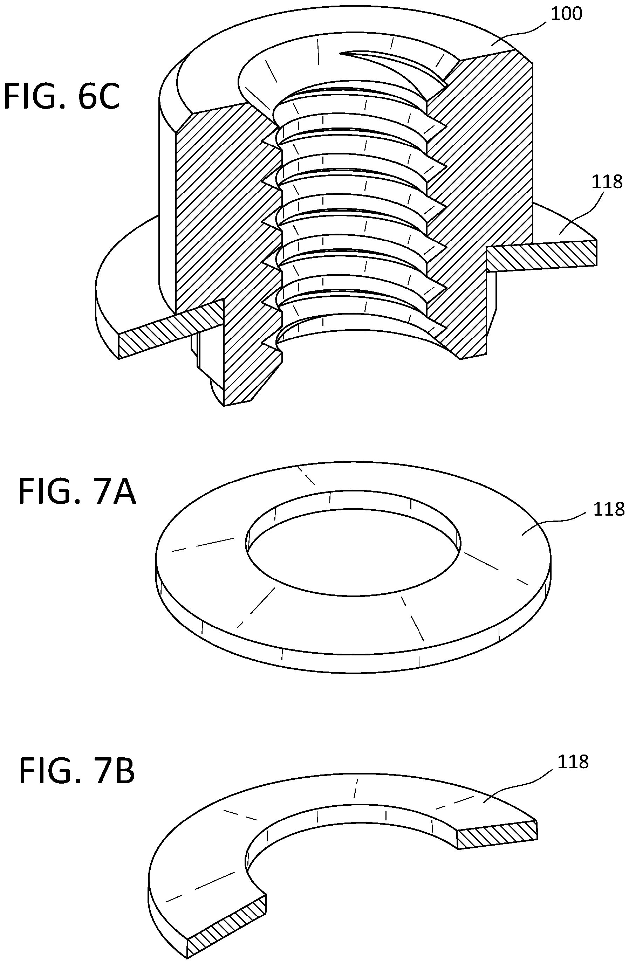

Another approach to solving the gap problem is to use a washer between the clinch nut 100 and the conductive pad 204. FIGs. 6A-6C illustrate the use of a washer 118 with the clinch nut 100. The washer 118 may be captured in the gap 112 between the ridges 110 and the head bottom surface 114. In other embodiments where there are no ridges 110, the washer 118 may still be used, but is not captured on the clinch nut 100. The washer 118 is illustrated as being a conical washer. The conical washer may have its concave side towards the PCB 202 (as illustrated in FIGs. 6A-6C) or towards the clinch nut 100 (not shown).

FIGs. 7A and 7B illustrate a top perspective and cross-sectional view of the washer 118. The washer 118 has a slightly conical shape that allows for some compression when used with the clinch nut 100. As a result, the washer 118 can also prevent any break in electrical connectivity between the clinch nut 100 and the PCB 202. In other embodiments, the washer 118 may be flat, but may be made of a soft and/or malleable compressible material that allows for compression when the clinch nut 100 is pressed against the washer 118. This may compensate for variations in the tolerances of the clinch nuts 100. In yet another embodiment, the washer 118 may be a split washer, i.e., the washer has a break and the ends of the break are offset from one another. This washer design allows for variations in compression between the head bottom surface 114 and the conductive pad 204, and it will facilitate maintaining electrical connectivity between multiple clinch nuts 100 and the conductive pads 204.

While each of the embodiments are described above in terms of their structural arrangements, it should be appreciated that the invention also covers the associated methods of using the embodiments described above.

Although the various exemplary embodiments have been described in detail with particular reference to certain exemplary aspects thereof, it should be understood that the invention is capable of other embodiments and its details are capable of modifications in various obvious respects. As is readily apparent to those skilled in the art, variations and modifications and combinations of the various embodiments can be affected while remaining within the spirit and scope of the invention. Accordingly, the foregoing disclosure, description, and figures are for illustrative purposes only and do not in any way limit the invention, which is defined only by the claims.

## Claims

1. A printed circuit board (PCB) comprising:
a first through hole;
a first conductive pad on a surface of the PCB, wherein the first conductive pad has a first surface treatment;
a reflowed solder layer on the first surface treatment; and
a first clinch nut pressed into the first through hole, wherein the first clinch nut is pressed into contact with the solder layer to create electrical connectivity between the first clinch nut and the first conductive pad.

2. The PCB of claim 1, wherein the first clinch nut includes ridges that contact an inner surface of the first through hole.

3. The PCB of claim 1, wherein the solder layer extends continuously around the first through hole.

4. The PCB of claim 1, wherein the solder layer includes separate solder portions placed at separate locations around the first through hole.

5. The PCB of claim 1, further comprising:
a second through hole;
a second conductive pad on a surface of the PCB, wherein the second conductive pad has a second surface treatment;
a reflowed solder layer on the second treatment surface; and
a second clinch nut pressed into the second through hole, wherein the second clinch nut is pressed into contact with the solder layer to create electrical connectivity between the second clinch nut and the second conductive pad.

6. A method of manufacturing a printed circuit board (PCB) comprising:
placing solder on a surface treatment of a first conductive pad on a surface of the PCB, wherein the first conductive pad is around a first through hole;
reflowing said solder; and
pressing a first clinch nut into the solder to create electrical connectivity between the first clinch nut and the first conductive pad.

7. The method of claim 6, wherein the first clinch nut includes ridges that contact an inner surface of the first through hole.

8. The method of claim 6, wherein the solder extends continuously around the first through hole.

9. The method of claim 6, wherein the solder includes separate solder portions placed at separate locations around the first through hole.

10. The method of claim 6, further comprising:
placing solder on a surface treatment of a second conductive pad on the surface of the PCB, wherein the second conductive pad is around a second through hole; and
pressing a second clinch nut into the solder to create electrical connectivity between the second clinch nut and the second conductive pad.

11. A printed circuit board (PCB) comprising:
a first through hole;
a first conductive pad on a surface of the PCB;
a first clinch nut pressed into the first through hole; and
a first washer around an insert portion of the first clinch nut, wherein the first washer is in contact with and between the first clinch nut and the first conductive pad and the first washer creates electrical connectivity between the first clinch nut and the first conductive pad.

12. The PCB of claim 11, wherein the first clinch nut includes ridges that contact an inner surface of the first through hole.

13. The PCB of claim 11, wherein the first washer is a conical washer.

14. The PCB of claim 11, wherein the first washer is made of a soft malleable and compressible conductive material.

15. The PCB of claim 11, further comprising:
a second through hole;
a second conductive pad on a surface of the PCB;
a second clinch nut pressed into the second through hole; and
a second washer around an insert portion of the second clinch nut, wherein the second washer is in contact with and between the second clinch nut and the second conductive pad and the second washer creates electrical connectivity between the second clinch nut and the second conductive pad.
